(19) Europäisches Patentamt
European Patent Office
Office européen des brevets

(11) **EP 1 746 729 A1**

(12) **DEMANDE DE BREVET EUROPEEN**

(43) Date de publication:
**24.01.2007 Bulletin 2007/04**

(51) Int Cl.:
***H03L 7/097*** *(2006.01)*

(21) Numéro de dépôt: **06117608.7**

(22) Date de dépôt: **20.07.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **22.07.2005 FR 0507868**

(71) Demandeur: **ATMEL NANTES SA**
**44306 Nantes Cédex 3 (FR)**

(72) Inventeurs:
• **Gibet, Stanislas**
**44470 Carquefou (FR)**

• **Bendraoui, Abdellatif**
**44450 Saint-Julien de Concelles (FR)**
• **Tual, Mikaël**
**44600 Saint-Nazaire (FR)**

(74) Mandataire: **Guéné, Patrick Lucien Juan Joseph**
**Cabinet Vidon**
**Technopôle Atalante**
**16B, rue de Jouanet**
**35703 Rennes Cedex (FR)**

Remarques:
Revendications modifiées conformément à la règle 86 (2) CBE.

(54) **Dispositif de génération d'une fréquence de référence et circuit électronique correspondant**

(57) L'invention concerne un dispositif de génération d'une fréquence de référence.

Selon l'invention, un tel dispositif comprend :

- des moyens de génération (11) d'une tension de référence ; et
- des moyens d'asservissement (12) de la fréquence de référence sur la tension de référence.

Fig. 1

EP 1 746 729 A1

**Description**

**1. Domaine de l'invention**

La présente invention se rapporte au domaine de la génération d'une fréquence de référence.
Plus précisément, l'invention concerne la génération d'une fréquence de référence à partir d'un oscillateur intégré présentant une grande précision (de l'ordre de 5% ou moins) et ne nécessitant pas l'utilisation de composants externes.

**2. Art antérieur**

On connaît différents types d'oscillateurs présentant une précision variable en fonction des variations des conditions de fonctionnement de l'oscillateur, c'est-à-dire en fonction des variations de process, de température, et/ou de tension d'alimentation.
Ainsi, certains oscillateurs, tels que les oscillateurs à quartz par exemple, permettent d'obtenir une précision en fréquence de l'ordre de 1%.
Cependant, un inconvénient de ces oscillateurs est qu'ils reposent sur l'utilisation d'au moins un composant externe pour accroître leur précision.
De même, certains oscillateurs sont mis en oeuvre en utilisant des composants de type résistances ou capacités externes permettant de générer une base de temps précise.
Il existe également d'autres oscillateurs, présentant par exemple une structure en anneau, ne nécessitant pas l'utilisation de composants externes.
Toutefois, de tels oscillateurs présentent généralement une précision moins fine (de l'ordre de 30%) que les oscillateurs utilisant un composant externe.
Pour améliorer leur précision, il est alors nécessaire d'avoir recours à un système de calibration, par exemple en ajoutant des bits permettant la programmation d'un délai ou d'une capacité, ou en utilisant une matrice de fusibles que l'on peut griller lors de tests. Les oscillateurs ainsi obtenus présentent une précision de l'ordre de 5%.
Cependant, un inconvénient de ces systèmes de calibration est qu'ils nécessitent l'utilisation d'un registre à charger (par exemple de type RAM, de l'anglais « Random Access Memory », en français mémoire vive) lorsque l'on ajoute des bits de programmation, ou une très grande surface de circuit (de l'ordre du double de l'oscillateur) lorsque l'on utilise une matrice de fusibles.

**3. Objectifs de l'invention**

L'invention a notamment pour objectif de pallier ces inconvénients de l'art antérieur.
Plus précisément, un objectif de l'invention est de fournir une technique de génération d'une fréquence de référence présentant une précision accrue par rapport aux techniques de l'art antérieur (de l'ordre de 5% ou moins).
L'invention a notamment pour objectif de fournir une telle technique ne reposant pas sur l'utilisation de composants externes pour accroître la précision de la fréquence d'oscillation.
L'invention a encore pour objectif de fournir une telle technique qui soit simple à implémenter et peu coûteuse à mettre en oeuvre.
Notamment, un objectif de l'invention est de fournir une telle technique comprenant des moyens occupant une place réduite sur un circuit intégré.

**4. Exposé de l'invention**

Ces objectifs, ainsi que d'autres qui apparaîtront par la suite, sont atteints à l'aide d'un dispositif de génération d'une fréquence de référence.
Selon l'invention, un tel dispositif comprend :

- des moyens de génération d'une tension de référence ; et
- des moyens d'asservissement de la fréquence de référence sur la tension de référence.

Le principe général de l'invention repose ainsi sur une approche tout à fait nouvelle et inventive de l'asservissement d'une fréquence sur une tension de référence, et non sur une fréquence, permettant de générer une fréquence de référence présentant une grande précision (de l'ordre de 1 à 5%).
Les moyens de génération d'une tension de référence peuvent notamment comprendre un générateur de type Bandgap, permettant de générer une tension de référence stable et précise.

L'invention propose ainsi un oscillateur intégré générant une fréquence de référence présentant une grande précision, sans nécessiter l'utilisation de composants externes.

Avantageusement, les moyens d'asservissement comprennent des moyens de conversion de la fréquence de référence en tension, délivrant une tension image de la fréquence de référence.

Ces moyens de conversion permettent ainsi de transformer la fréquence de référence en une tension image, pour pouvoir la comparer à la tension de référence, et délivrer ensuite une fréquence de référence précise.

De manière préférentielle, les moyens d'asservissement comprennent également des moyens de comparaison de la tension image à la tension de référence, et un oscillateur contrôlé en tension délivrant la fréquence de référence en fonction d'un signal de sortie des moyens de comparaison.

Selon l'invention, l'oscillateur contrôlé en tension, encore appelé VCO (de l'anglais « Voltage Controlled Oscillator »), est commandé par un signal de sortie issu des moyens de comparaison, comparant la tension image de la fréquence de référence avec la tension de référence.

L'invention repose ainsi sur un asservissement de la fréquence du VCO à la tension de référence.

De façon avantageuse, les moyens de conversion comprennent un convertisseur fréquence-tension présentant une fonction de transfert indépendante des variations des conditions de fonctionnement du dispositif.

On entend notamment par variations des conditions de fonctionnement les variations de process, de température, et/ou d'une tension d'alimentation.

Préférentiellement, les moyens de conversion comprennent des moyens de charge d'au moins une capacité, délivrant une tension intermédiaire, et des moyens de lissage de la tension intermédiaire, délivrant la tension image.

Ces moyens de lissage permettent notamment d'extraire la valeur moyenne de la tension intermédiaire, pour délivrer la tension image.

Selon un premier mode de réalisation de l'invention, les moyens de charge comprennent :

- une résistance alimentée par une tension d'alimentation et connectée à l'entrée des moyens de lissage ;
- une capacité et un interrupteur en parallèle, connectés entre la masse et l'entrée des moyens de lissage, l'interrupteur étant piloté par un signal de commutation à la fréquence de référence.

Selon un second mode de réalisation, les moyens de charge comprennent :

- une capacité commutée alimentée par une tension d'alimentation et connectée à l'entrée des moyens de lissage, la capacité commutée comprenant au moins un interrupteur piloté par un signal de commutation à la fréquence de référence ; et
- une capacité et un interrupteur en parallèle, connectés entre la masse et l'entrée des moyens de lissage, l'interrupteur étant piloté par le signal de commutation.

L'utilisation de capacités commutées permet notamment d'obtenir des rapports précis entre les différents composants (résistance, capacité, ..).

Selon une variante de l'invention, le dispositif de génération d'une fréquence de référence comprend des moyens de programmation des moyens de génération d'une tension de référence et/ou des moyens de programmation des moyens de conversion de la fréquence de référence en tension, de façon à régler la fréquence de référence.

Ces moyens de programmation permettent notamment de modifier la fréquence de référence générée par le dispositif selon l'invention.

Plus précisément, selon une utilisation particulière de l'invention, le dispositif de génération d'une tension de référence peut se comporter comme une boucle à verrouillage de phase, encore appelée PLL (de l'anglais « Phase Locked Loop »), couplée à un oscillateur classique, par exemple pour mettre en oeuvre une synthèse de fréquence.

L'invention concerne également un circuit électronique comprenant un dispositif de génération d'une fréquence de référence selon l'invention tel que décrit précédemment.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente le fonctionnement général d'un dispositif de génération d'une fréquence de référence selon l'invention ;
- les figures 2A et 2B illustrent deux variantes de réalisation des moyens de conversion fréquence-tension du dispositif présenté en figure 1 ;

- les figures 3A à 3C présentent les variations de la tension en fonction de la charge ou décharge d'une capacité des moyens de conversion fréquence-tension des figures 2A et 2B ;
- la figure 4 illustre une variante de réalisation de l'invention selon laquelle la fréquence de référence générée par le dispositif de la figure 1 est réglable
- la figure 5 présente un synthétiseur de fréquence selon l'art antérieur.

## 6. Description d'un mode de réalisation de l'invention

Le principe général de l'invention repose sur l'asservissement d'une fréquence de référence, générée en sortie d'un oscillateur, non pas sur une fréquence, mais sur une tension de référence.

Ainsi, l'invention repose sur l'utilisation de moyens de génération d'une tension de référence, délivrant une tension de référence stable et précise, et de moyens d'asservissement de la fréquence de référence sur la tension de référence.

Selon l'invention, ces moyens d'asservissement comprennent des moyens de conversion fréquence-tension, permettant de convertir la fréquence de référence en une tension image, pour comparer cette tension image à la tension de référence, et délivrer un signal de sortie commandant un oscillateur contrôlé en tension en fonction du résultat de la comparaison, délivrant la fréquence de référence.

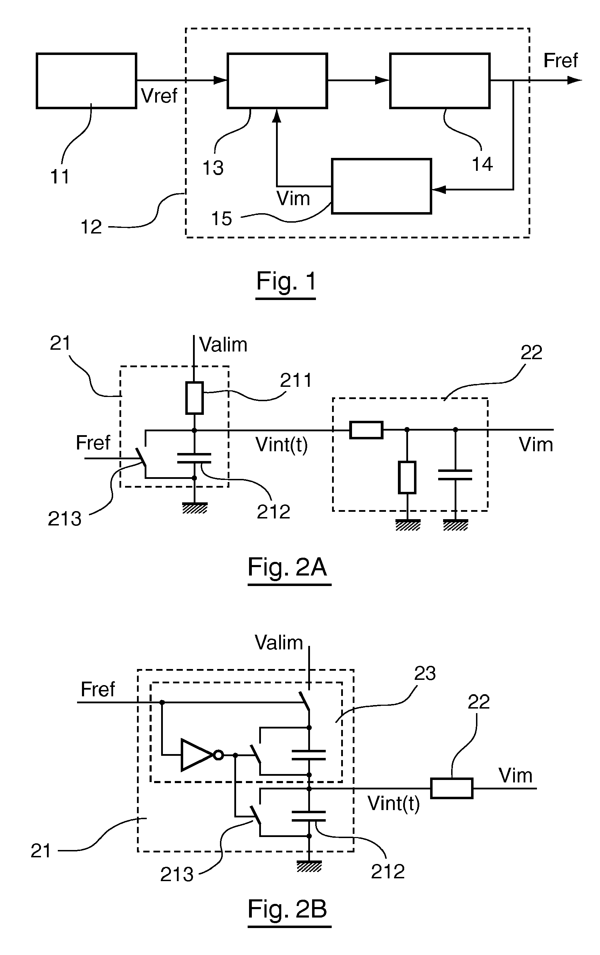

On présente en relation avec la figure 1 un mode de réalisation préférentiel de l'invention.

Selon ce mode de réalisation préférentiel, le dispositif de génération d'une fréquence de référence $F_{ref}$ selon l'invention comprend des moyens de génération 11 d'une tension de référence, délivrant une tension de référence $V_{ref}$, et des moyens d'asservissement 12 de la fréquence de référence $F_{ref}$ sur la tension de référence $V_{ref}$.

La tension de référence $V_{ref}$ peut notamment être générée par un générateur de type Bandgap, bien connu de l'Homme du Métier pour la précision de la tension générée vis-à-vis des variations des conditions de fonctionnement (précision de l'ordre de 1 à 5% vis-à-vis des variations de process, de température, de la tension d'alimentation, des paramètres technologiques de fabrication des composants...).

Plus précisément, les moyens d'asservissement 12 comprennent des moyens de conversion fréquence-tension 15 permettant de convertir la fréquence de référence $F_{ref}$ en une tension image $V_{im}$, et des moyens de comparaison 13 permettant de comparer la tension image $V_{im}$ à la tension de référence $V_{ref}$.

Selon ce mode de réalisation préférentiel, les moyens de conversion fréquence-tension 15 présentent une fonction de transfert K indépendante des variations des conditions de fonctionnement du dispositif, c'est-à-dire indépendante des variations de process, de température, et/ou de la tension d'alimentation :

$$V_{im} = K.F_{ref}$$

Les moyens de comparaison 13 délivrent un signal de sortie proportionnel à la différence entre la tension de référence $V_{ref}$ en sortie du générateur de tension 11 et la tension $V_{im}$ en sortie des moyens de conversion fréquence-tension 15.

Plus précisément, ces moyens de comparaison 13 mettent en oeuvre une soustraction de la tension image $V_{im}$ à la tension de référence $V_{ref}$, et une multiplication du résultat de cette soustraction par un gain G, délivrant le signal de sortie à la tension $V_{vco}$:

$$V_{VCO} = (V_{ref} - V_{im}).G$$

Ce signal de sortie permet notamment la commande d'un oscillateur contrôlé en tension 14 (encore appelé VCO), de fonction de transfert $I$, délivrant un signal dont la fréquence de référence $F_{ref}$ varie en fonction de la tension $V_{VCO}$ appliquée sur son entrée :

$$F_{ref} = V_{VCO}.I$$

Ainsi, pour générer une fréquence de référence précise, il est nécessaire d'asservir la fréquence du VCO 14 à une tension précise, et donc de commander le VCO avec le signal de sortie issu de la comparaison entre la tension de référence $V_{ref}$ générée par un générateur 11 de type Bandgap et la tension image de la fréquence de référence $V_{im}$.

Un tel oscillateur commandé en tension est classique et bien connu de l'Homme du Métier, notamment dans les circuits électroniques à base de boucle à verrouillage de phase (PLL).

L'invention propose ainsi de générer une fréquence de référence $F_{ref}$ en utilisant des composants classiques, et notamment un générateur de tension de référence, un comparateur et un oscillateur contrôlé en tension.

La précision de la fréquence de référence générée repose alors sur les moyens de conversion fréquence-tension, et peut s'écrire sous la forme :

$$F_{ref} = V_{VCO}.I = (V_{ref} - V_{im}).G.I = (V_{ref} - K.F_{ref}).G.I = V_{ref}.G.I - K.F_{ref}.G.I$$

soit encore :

$$F_{ref}.(1 + K.G.I) = V_{ref}.G.I$$

ou encore :

$$F_{ref} = V_{ref}.\frac{G.I}{1 + K.G.I}$$

On en déduit que la précision de la fréquence de référence $F_{ref}$ est la même que celle de la tension de référence $V_{ref}$.

Ainsi, si les moyens de génération 11 d'une tension de référence comprennent un générateur de type Bandgap, dont la précision est de l'ordre de 1 à 5%, la précision de la fréquence de référence $F_{ref}$ générée par le dispositif de génération selon l'invention sera de l'ordre de 1 à 5%.

De plus, le dispositif selon l'invention peut être entièrement intégré, puisqu'il ne nécessite pas l'utilisation de composants externes.

On peut tout de même remarquer que l'oscillateur selon l'invention peut être réalisé sur deux circuits différents, un premier circuit classique comprenant les moyens de génération 11 d'une tension de référence de type Bandgap et un second circuit comprenant les moyens d'asservissement 12 de la fréquence de référence $F_{ref}$ sur la tension de référence $V_{ref}$, alimenté par la tension de référence $V_{ref}$.

On peut également remarquer que lorsque la tension de référence $V_{ref}$ est égale à la tension image $V_{im}$, la fréquence de référence $F_{ref}$ en sortie du dispositif selon l'invention devient nulle.

Or si la fréquence de référence $F_{ref}$ est nulle, alors la tension image $V_{im}$ est également nulle, et la tension en sortie des moyens de comparaison 13 devient :

$$V_{VCO} = (V_{ref} - V_{im}).G = V_{ref}.G$$

Dans ce cas, selon les équations précédentes, la fréquence de référence $F_{ref}$ peut s'écrire sous la forme :

$$F_{ref} = V_{VCO}.I = V_{ref}.G.I$$

On en déduit que l'état selon lequel la tension de référence $V_{ref}$ est égale à la tension image $V_{im}$ n'est pas un état stable.

Cette instabilité est propre aux systèmes comprenant une boucle de réaction : la boucle de réaction tend à créer l'égalité entre la tension de référence $V_{ref}$ et la tension image $V_{im}$, et une fois cette égalité atteinte, la fréquence de référence $F_{ref}$ décroît, puis la tension image $V_{im}$ varie de nouveau, et la boucle de réaction tend de nouveau à créer l'égalité.

Ainsi, comme dans tout système comprenant une boucle de réaction, il est souhaitable d'ajouter un élément de retard qui assure la stabilité du système.

On présente désormais en relation avec les **figures 2A** et **2B** deux modes de réalisation des moyens de conversion fréquence-tension 15.

Selon un premier mode de réalisation, illustré en **figure 2A**, les moyens de conversion fréquence-tension 15 comprennent des moyens de charge 21 d'au moins une capacité, délivrant une tension intermédiaire $V_{int}(t)$ variant au cours du temps, et des moyens de lissage 22 de la tension intermédiaire $V_{int}(t)$, délivrant la tension image $V_{im}$.

Les moyens de charge comprennent notamment :

- une résistance 211 alimentée par une tension d'alimentation $V_{alim}$ et connectée à l'entrée des moyens de lissage 22 ; et
- une capacité 212 et un interrupteur 213 en parallèle, connectés entre la masse et l'entrée des moyens de lissage 22, l'interrupteur 213 étant piloté par un signal de commutation à la fréquence de référence $F_{ref}$.

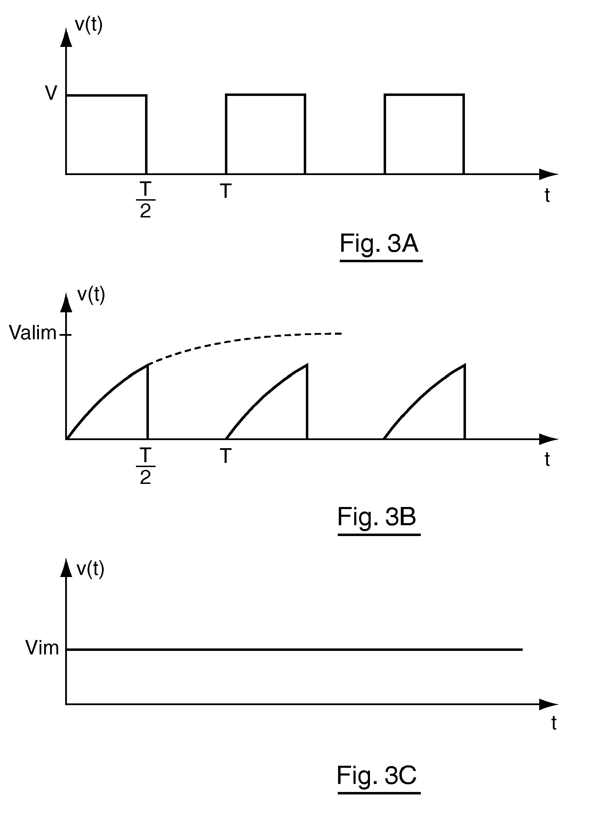

La **figure 3A** illustre notamment le signal de commutation de la capacité 212 à la fréquence $F_{ref}$ pilotant l'interrupteur 213.

Ainsi, pendant une première période T/2, l'interrupteur 213 est ouvert et la capacité 212 se charge, et pendant la période T/2 suivante, l'interrupteur 213 est fermé et la capacité 212 se décharge (avec T = 1/$F_{ref}$).

La **figure 3B** illustre plus précisément les variations de la tension intermédiaire $V_{int}(t)$ aux bornes de la capacité 212 en fonction du temps.

Ainsi, pendant la première période T/2, la tension intermédiaire $V_{int}(t)$ aux bornes de la capacité 212 croît de façon non linéaire (régime transitoire) en vue d'atteindre la valeur de la tension d'alimentation $V_{alim}$ (en pointillé sur la figure). Lorsque l'interrupteur 213 se ferme (période T/2 suivante), créant un court-circuit à la fréquence $F_{ref}$, la capacité 212 se décharge brusquement et la tension intermédiaire $V_{int}(t)$ aux bornes de la capacité 212 devient quasiment nulle. Les paramètres influençant la rapidité de cette évolution sont la résistance 211 et la capacité 212.

Les moyens de conversion fréquence-tension 15 comprennent également des moyens de lissage 22 de la tension intermédiaire $V_{int}(t)$, permettant d'extraire la valeur moyenne de la tension intermédiaire, et délivrant la tension image $V_{im}$, telle qu'illustrée en **figure 3C**.

Ces moyens de lissage 22 comprennent par exemple une première résistance alimentée par la tension intermédiaire $V_{int}(t)$, et une seconde résistance et une capacité en parallèle connectées entre la masse et la sortie de la première résistance, délivrant un signal à la tension image $V_{im}$.

Selon un second mode de réalisation, illustré en **figure 2B**, les moyens de conversion fréquence-tension 15 comprennent des moyens de charge 21 d'au moins une capacité, délivrant une tension intermédiaire $V_{int}(t)$ variant au cours du temps, et des moyens de lissage 22 de la tension intermédiaire $V_{int}(t)$, délivrant la tension image $V_{im}$.

Plus précisément, les moyens de charge comprennent :

- une capacité commutée 23 alimentée par une tension d'alimentation $V_{alim}$ et connectée à l'entrée des moyens de lissage 22, la capacité commutée 23 comprenant au moins un interrupteur piloté par un signal de commutation à la fréquence de référence ; et
- une capacité 212 et un interrupteur 213 en parallèle, connectés entre la masse et l'entrée des moyens de lissage 22, l'interrupteur étant piloté par le signal de commutation.

Autrement dit, la résistance 211 du premier mode de réalisation des moyens de conversion fréquence-tension est remplacée par un système 23 à capacités commutées. L'utilisation de capacités commutées permet notamment d'obtenir des rapports précis entre les différents composants (résistance, capacité, ...), et par conséquent d'obtenir une tension image $V_{im}$ précise.

On peut remarquer que les capacités commutées sont classiquement utilisées dans la génération de filtres.

L'invention repose en revanche sur une utilisation originale des capacités commutées pour la conversion d'une fréquence en tension. Ainsi, selon l'invention, les interrupteurs des capacités commutées sont pilotés par un signal de commutation à la fréquence de référence $F_{ref}$. La fréquence de référence est donc utilisée dans ce cas comme une donnée d'entrée du système à capacité commutée.

Le fonctionnement de la capacité 212 et de l'interrupteur 213 en parallèle, ainsi que celui des moyens de lissage 22, déjà présenté en relation avec la figure 2A, et n'est pas décrit plus précisément.

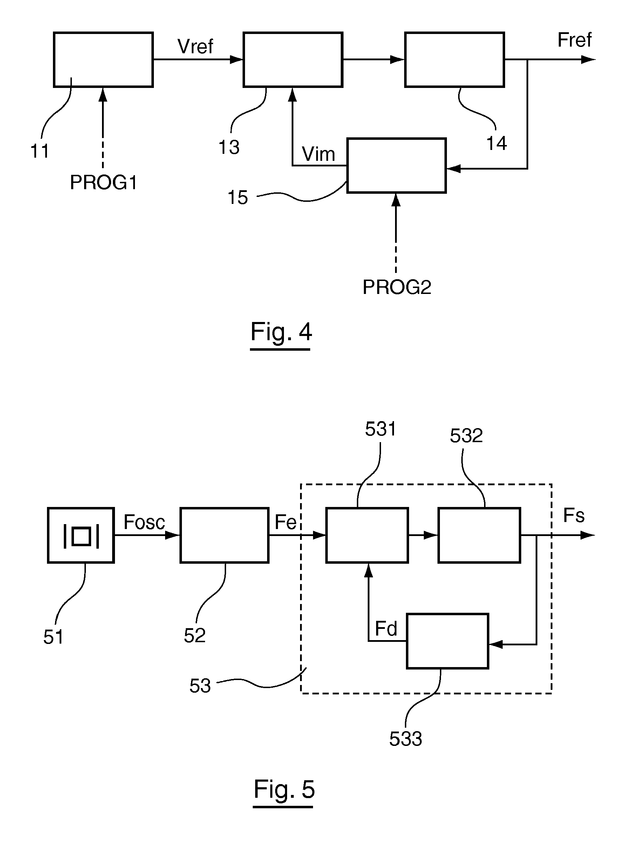

On présente désormais en relation avec la **figure 4** une variante de réalisation selon laquelle la fréquence de référence $F_{ref}$ est réglable.

Plus précisément, selon cette variante de l'invention, le dispositif de génération d'une fréquence de référence comprend des moyens de programmation PROG1 des moyens de génération 11 d'une tension de référence et/ou des moyens de programmation PROG2 des moyens de conversion 15 de la fréquence de référence en tension.

En effet, comme précisé précédemment, la fréquence de référence en sortie du dispositif peut s'exprimer sous la forme :

$$F_{ref} = V_{ref} \cdot \frac{G.I}{1 + K.G.I}$$

Par conséquent, si la valeur de la fonction de transfert K des moyens de conversion fréquence-tension 15 est programmable, avec les moyens de programmation PROG2, ou si la valeur de la tension de référence $V_{ref}$ est programmable, avec les moyens de programmation PROG 1, alors la fréquence de référence $F_{ref}$ générée par l'oscillateur selon l'invention peut être réglée différemment en fonction des applications.

On peut ainsi programmer soit les moyens de génération 11 de la tension de référence, soit les moyens de conversion fréquence-tension 15, soit les deux, si l'on souhaite pouvoir régler la fréquence de référence au cours des utilisations.

Il suffit pour cela d'avoir un oscillateur contrôlé en fréquence 14 qui couvre la plage de fréquence nécessaire, et de pouvoir adapter la transmittance du convertisseur fréquence-tension. On peut noter que la plage de fonctionnement prévisible est de l'ordre de 12 à 500MHz.

Un exemple d'application est la réalisation d'un synthétiseur de fréquence en programmant les moyens de génération 11 de la tension de référence et/ou les moyens de conversion fréquence-tension 15.

Le dispositif de génération d'une fréquence de référence selon l'invention peut ainsi remplacer un système classique de synthèse de fréquence associant un oscillateur à quartz à une boucle à verrouillage de phase (encore appelée PLL, de l'anglais « Phase Locked Loop »).

Plus précisément, un synthétiseur classique de fréquence, tel qu'illustré en **figure 5**, associe un oscillateur à quartz 51, délivrant une fréquence $F_{osc}$, à une boucle à verrouillage de phase 53, par l'intermédiaire d'un diviseur de fréquence 52 délivrant une fréquence d'entrée $F_e$.

Une telle boucle à verrouillage de phase 53 comprend au moins un comparateur de phase 531, un oscillateur contrôlé en tension 532 (VCO), et un diviseur 533, et permet de générer une fréquence quelconque avec la même précision que celle de l'oscillateur à quartz.

Plus précisément, le comparateur 531 compare la fréquence d'entrée $F_e$ et la fréquence $F_d$ en sortie du diviseur 533 de la PLL, inséré dans la boucle de réaction entre la sortie du VCO 532 et l'entrée du comparateur 531, et délivre un signal de contrôle commandant l'oscillateur contrôlé en tension 532. Le VCO 532 délivre un signal de sortie à la fréquence $F_s$.

Ainsi, selon l'invention, on peut remplacer un synthétiseur de fréquence classique tel que celui illustré en figure 5, c'est-à-dire comprenant un oscillateur à quartz et une PLL, par un dispositif de génération d'une fréquence de référence selon l'invention.

On peut donc remplacer un oscillateur à quartz précis par un oscillateur intégré précis selon l'invention, ne nécessitant pas l'utilisation de composants externes, et s'affranchir de la boucle à verrouillage de phase en modifiant les paramètres de l'oscillateur, à partir des moyens de programmation PROG 1 et/ou PROG 2.

Il est par exemple possible de modifier le seuil des moyens de comparaison 13, comparant la tension de référence $V_{ref}$ à la tension image $V_{im}$, en modifiant la valeur de la tension de référence $V_{ref}$

Finalement, l'oscillateur selon l'invention permet de fournir une fréquence de référence précise, sans composant externe, et peut selon son application remplacer le couple « oscillateur à quartz-PLL » utilisé dans la synthèse de fréquence.

**Revendications**

1. Dispositif de génération d'une fréquence de référence,
   **caractérisé en ce qu'**il comprend :

   - des moyens de génération (11) d'une tension de référence ; et
   - des moyens d'asservissement (12) de ladite fréquence de référence sur ladite tension de référence.

2. Dispositif de génération d'une fréquence de référence selon la revendication 1, **caractérisé en ce que** lesdits moyens d'asservissement (12) comprennent des moyens de conversion (15) de ladite fréquence de référence en tension, délivrant une tension image de ladite fréquence de référence.

3. Dispositif de génération d'une fréquence de référence selon la revendication 2, **caractérisé en ce que** lesdits moyens d'asservissement (12) comprennent également des moyens de comparaison (13) de ladite tension image à ladite tension de référence, et un oscillateur contrôlé en tension (14) délivrant ladite fréquence de référence en fonction d'un signal de sortie desdits moyens de comparaison (13).

**4.** Dispositif de génération d'une fréquence de référence selon l'une quelconque des revendications 2 et 3, **caractérisé en ce que** lesdits moyens de conversion (15) comprennent un convertisseur fréquence-tension présentant une fonction de transfert indépendante des variations des conditions de fonctionnement dudit dispositif.

**5.** Dispositif de génération d'une fréquence de référence selon l'une quelconque des revendications 2 à 4, **caractérisé en ce que** lesdits moyens de conversion (15) comprennent des moyens de charge (21) d'au moins une capacité, délivrant une tension intermédiaire, et des moyens de lissage (22) de ladite tension intermédiaire, délivrant ladite tension image.

**6.** Dispositif de génération d'une fréquence de référence selon la revendication 5, **caractérisé en ce que** lesdits moyens de charge (21) comprennent :

- une résistance alimentée par une tension d'alimentation et connectée à l'entrée desdits moyens de lissage ;
- une capacité et un interrupteur en parallèle, connectés entre la masse et l'entrée desdits moyens de lissage, ledit interrupteur étant piloté par un signal de commutation à ladite fréquence de référence.

**7.** Dispositif de génération d'une fréquence de référence selon la revendication 5, **caractérisé en ce que** lesdits moyens de charge (21) comprennent :

- une capacité commutée alimentée par une tension d'alimentation et connectée à l'entrée desdits moyens de lissage, ladite capacité commutée comprenant au moins un interrupteur piloté par un signal de commutation à ladite fréquence de référence ; et
- une capacité et un interrupteur en parallèle, connectés entre la masse et l'entrée desdits moyens de lissage, ledit interrupteur étant piloté par ledit signal de commutation.

**8.** Dispositif de génération d'une fréquence de référence selon l'une quelconque des revendications 1 à 7, **caractérisé en ce que** lesdits moyens de génération (11) d'une tension de référence comprennent un générateur de type Bandgap.

**9.** Dispositif de génération d'une fréquence de référence selon l'une quelconque des revendication 2 à 8, **caractérisé en ce qu'**il comprend des moyens de programmation desdits moyens de génération (11) d'une tension de référence et/ou des moyens de programmation desdits moyens de conversion (15) de ladite fréquence de référence en tension, de façon à régler ladite fréquence de référence.

**10.** Circuit électronique **caractérisé en ce qu'**il comprend un dispositif de génération d'une fréquence de référence selon l'une quelconque des revendications 1 à 9.

**Revendications modifiées conformément à la règle 86(2) CBE.**

**1.** Dispositif de génération d'une fréquence de référence,
**caractérisé en ce qu'**il comprend :

- des moyens de génération (11) d'une tension de référence ne comprenant pas de moyens de conversion fréquence/tension ; et
- des moyens d'asservissement (12) de ladite fréquence de référence sur ladite tension de référence, de façon que ledit dispositif bénéficie de la précision desdits moyens de génération.

**2.** Dispositif de génération d'une fréquence de référence selon la revendication 1, **caractérisé en ce que** lesdits moyens d'asservissement (12) comprennent des moyens de conversion (15) de ladite fréquence de référence en tension, délivrant une tension image de ladite fréquence de référence.

**3.** Dispositif de génération d'une fréquence de référence selon la revendication 2, **caractérisé en ce que** lesdits moyens d'asservissement (12) comprennent également des moyens de comparaison (13) de ladite tension image à ladite tension de référence, et un oscillateur contrôlé en tension (14) délivrant ladite fréquence de référence en fonction d'un signal de sortie desdits moyens de comparaison (13).

**4.** Dispositif de génération d'une fréquence de référence selon l'une quelconque des revendications 2 et 3, **caractérisé en ce que** lesdits moyens de conversion (15) comprennent un convertisseur fréquence-tension présentant une fonction de transfert indépendante des variations des conditions de fonctionnement dudit dispositif.

**5.** Dispositif de génération d'une fréquence de référence selon l'une quelconque des revendications 2 à 4, **caractérisé en ce que** lesdits moyens de conversion (15) comprennent des moyens de charge (21) d'au moins une capacité, délivrant une tension intermédiaire, et des moyens de lissage (22) de ladite tension intermédiaire, délivrant ladite tension image.

**6.** Dispositif de génération d'une fréquence de référence selon la revendication 5, **caractérisé en ce que** lesdits moyens de charge (21) comprennent :

- une résistance alimentée par une tension d'alimentation et connectée à l'entrée desdits moyens de lissage ;
- une capacité et un interrupteur en parallèle, connectés entre la masse et l'entrée desdits moyens de lissage, ledit interrupteur étant piloté par un signal de commutation à ladite fréquence de référence.

**7.** Dispositif de génération d'une fréquence de référence selon la revendication 5, **caractérisé en ce que** lesdits moyens de charge (21) comprennent :

- une capacité commutée alimentée par une tension d'alimentation et connectée à l'entrée desdits moyens de lissage, ladite capacité commutée comprenant au moins un interrupteur piloté par un signal de commutation à ladite fréquence de référence ; et
- une capacité et un interrupteur en parallèle, connectés entre la masse et l'entrée desdits moyens de lissage, ledit interrupteur étant piloté par ledit signal de commutation.

**8.** Dispositif de génération d'une fréquence de référence selon l'une quelconque des revendications 1 à 7, **caractérisé en ce que** lesdits moyens de génération (11) d'une tension de référence comprennent un générateur de type Bandgap.

**9.** Dispositif de génération d'une fréquence de référence selon l'une quelconque des revendication 2 à 8, **caractérisé en ce qu'**il comprend des moyens de programmation desdits moyens de génération (11) d'une tension de référence et/ou des moyens de programmation desdits moyens de conversion (15) de ladite fréquence de référence en tension, de façon à régler ladite fréquence de référence.

**10.** Circuit électronique **caractérisé en ce qu'**il comprend un dispositif de génération d'une fréquence de référence selon l'une quelconque des revendications 1 à 9.

Fig. 1

Fig. 2A

Fig. 2B

Fig. 3A

Fig. 3B

Fig. 3C

Fig. 4

Fig. 5

Office européen
des brevets

**RAPPORT DE RECHERCHE EUROPEENNE**

Numéro de la demande

EP 06 11 7608

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2001/038317 A1 (KASPERKOVITZ WOLFDIETRICH GEORG) 8 novembre 2001 (2001-11-08) | 1-4,8-10 | INV. H03L7/097 |
| Y | * alinéas [0014] - [0019]; figure 1 * ----- | 5 | |
| X | TING-PING LIU ET AL: "A 250MHZ MONOLITHIC VOLTAGE-CONTROLLED OSCILLATOR" IEEE INTERNATIONAL SOLID STATE CIRCUITS CONFERENCE, IEEE SERVICE CENTER, NEW YORK, NY, US, vol. 31, 17 février 1988 (1988-02-17), pages 22-23,283, XP000031769 ISSN: 0193-6530 * page 2221 - page 2222; figure 1 * ----- | 1-4,8-10 | |
| Y | MATSUMOTO H ET AL: "SWITCHED-CAPACITOR FREQUENCY-TO-VOLTAGE AND VOLTAGE-TO-FREQUENCY CONVERTERS BASED ON CHARGE-BALANCING PRINCIPLE" PROCEEDINGS OF THE INTERNATIONAL SYMPOSIUM ON CIRCUITS AND SYSTEMS. ESPOO, FINLAND, JUNE 7 - 9, 1988, NEW YORK, IEEE, US, vol. VOL. 3 CONF. 21, 7 juin 1988 (1988-06-07), pages 2221-2224, XP000043500 ISBN: 951-721-241-0 * page 22; figures 1,4 * ----- | 5 | |

| | | DOMAINES TECHNIQUES RECHERCHES (IPC) |
|---|---|---|
| | | H03L |

Le présent rapport a été établi pour toutes les revendications

| Lieu de la recherche | Date d'achèvement de la recherche | Examinateur |
|---|---|---|
| Munich | 11 octobre 2006 | Nicolaucig, Aldo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 06 11 7608

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-10-2006

| Document brevet cité au rapport de recherche | Date de publication | Membre(s) de la famille de brevet(s) | Date de publication |
|---|---|---|---|
| US 2001038317 A1 | 08-11-2001 | CN 1366734 A<br>WO 0180427 A1<br>JP 2003531549 T | 28-08-2002<br>25-10-2001<br>21-10-2003 |

Pour tout renseignement concernant cette annexe : voir Journal Officiel de l'Office européen des brevets, No.12/82

EPO FORM P0460